Europäisches Patentamt

European Patent Office

Office européen des brevets

(11) Veröffentlichungsnummer: **0 086 409**
**B1**

(12) **EUROPÄISCHE PATENTSCHRIFT**

(45) Veröffentlichungstag der Patentschrift:
**16.07.86**

(21) Anmeldenummer: **83101041.8**

(22) Anmeldetag: **04.02.83**

(51) Int. Cl.⁴: **G 01 R 25/08**

(54) Verfahren und Vorrichtung zur hochgenauen Messung der Phasenlage bzw. Phasenverschiebung zweier Impulsfolgen.

(30) Priorität: **15.02.82 DE 3205240**

(43) Veröffentlichungstag der Anmeldung:
**24.08.83 Patentblatt 83/34**

(45) Bekanntmachung des Hinweises auf die Patenterteilung:
**16.07.86 Patentblatt 86/29**

(84) Benannte Vertragsstaaten:
**AT BE CH DE FR GB IT LI LU NL SE**

(56) Entgegenhaltungen:
**DE - A - 1 806 916**
**DE - B - 2 758 525**
**FR - A - 2 277 346**
**GB - A - 1 439 553**
**US - A - 3 618 073**
**US - A - 4 181 884**

(73) Patentinhaber: **Forschungsgesellschaft Druckmaschinen e.V., Lyonerstrasse 18, D-6000 Frankfurt (DE)**

(72) Erfinder: **Spiegel, Nikolaus, Zellharder Strasse 14a, D-6107 Reinheim (DE)**
Erfinder: **Fischer, Rudolf, Dieburger Strasse 75, D-6100 Darmstadt (DE)**

(74) Vertreter: **Stoltenberg, Baldo Heinz-Herbert, c/o Heidelberger Druckmaschinen AG Kurfürsten-Anlage 52-60, D-6900 Heidelberg 1 (DE)**

## Beschreibung

Die Erfindung betrifft ein Verfahren und eine Vorrichtung zur hochgenauen Messung der Phasenlage bzw. Phasenverschiebung zweier Impulsfolgen, bei dem beispielsweise die Drehwinkel zweier Rotationskörper quantisiert, durch inkrementale Drehgeber in Impulsfolgen umgewandelt und diese zur Ermittlung der Phasenlage bzw. der Phasenverschiebung herangezogen werden.

Die Voraussetzung für den gleichmässigen Lauf eines Zahnrad- bzw. Reibradgetriebes ist ein konstantes Verhältnis der Winkelgeschwindigkeiten zwischen den Rädern der einzelnen Radpaarungen. Sobald zwischen treibendem und getriebenem Rad Geschwindigkeitsdifferenzen auftreten, wird der Gleichlauf beeinträchtigt; unerwünschte Übersetzungsfehler sind die Folge.

So sind z.B. bei Offsetdruckmaschinen, unabhängig von deren Konstruktionsprinzip, generell die Antriebsverhältnisse deren Zylinder (Platten-, Gummi- und Gegendruckzylinder) mehrfach statisch überbestimmt. Da die Zylinder sowohl formschlüssig durch Zahnräder (Stirnräder) als auch reibschlüssig durch Schmitzringe sowie ausserdem durch den Kontakt zwischen Druckplatte und Gummizylinder angetrieben werden, besteht ein Offsetdruckwerk aus mehreren dreifach überbestimmten Zweizylinder-Systemen. Da der formschlüssige Antrieb über die Zahnräder die Gleichheit der Drehzahl der Zylinder erzwingt, kann ein derartiges System nur dann funktionieren, wenn als Ausgleichsmechanismus ein Schlupf zwischen den den Kraftschluss bewirkenden Kontaktzonen auftritt, was wiederum zu Relativbewegungen in den farbübertragenen Zonen führt, welche Druckstörungen und Qualitätsminderungen verschiedenster Art verursachen können. Zur Beurteilung der Wirkung jeweils eines einzelnen Antriebes muss dessen Übersetzung, vollkommen unabhängig von weiteren vorhandenen Antrieben, möglichst genau ermittelt werden.

Hierzu ist es bekannt, an den Zapfen zweier zusammenwirkender benachbarter Zylinder eines Druckwerkes inkrementale Drehgeber anzubringen, die in Abhängigkeit von ihrer Teilung gemäss der Anzahl N der Inkremente auf ihrer Codierscheibe eine entsprechende Anzahl von Impulsen pro Zylinderumdrehung liefern, wodurch der Drehwinkel quantisiert wird. Von Quantisierung zu Quantisierung bzw. von Impuls zu Impuls wird dabei ein Winkel $\varphi_Q$ von 360°/N überstrichen. Während der Rotation der beiden Zylinder liefern die Ausgänge der Drehgeber zwei Impulsfolgen, die einerseits die Information bezüglich der momentanen Winkelgeschwindigkeit der einzelnen Zylinder, andererseits aber auch die Information über deren Differenzwinkelgeschwindigkeit enthalten. Zur exakten Bestimmung der Übersetzung wird eine Quotientenbildung zwischen der Differenzwinkelgeschwindigkeit und der Winkelgeschwindigkeit des treibenden Zylinders vorgenommen. Nach Elimination der Zeit stellt das Signal den vom anfänglichen Bezugspegel in einer bestimmten Zeitspanne aufgelaufenen Differenzdrehwinkel $\Delta\varphi$ – bezogen auf den zurückgelegten Winkel des treibenden Zylinders – dar.

Die Grösse des Differenzdrehwinkels pro Umdrehung

$$\frac{\Delta\varphi}{U}$$

hängt dabei von der jeweiligen Antriebsart ab. Bei formschlüssigem Antrieb mit einer Übersetzung der Verzahnung von i = I ist der Differenzdrehwinkel langfristig Null, kurzfristig schwankt er entsprechend dem vorhandenen Verzahnungsfehler um Null. An Druckmaschinenantrieben vorgenommene genaue Messungen haben ergeben, dass der auftretende Differenzdrehwinkel

$$\frac{\Delta\varphi}{U} \leq |10^{-4}|$$

beträgt und somit meist innerhalb einer Quantisierungsstufe (N = 10 000 Impulse) liegt. Bei reibschlüssigem Antrieb über die Schmitzringe kann sowohl der momentane wie auch der langfristige Differenzdrehwinkel innerhalb einer Quantisierungsstufe liegen. Die durch Fertigungstoleranzen bedingten, unterschiedlichen Umfänge der Schmitzringe bewirken eine langsame Zunahme des Differenzdrehwinkels in die eine oder andere Richtung, weshalb – will man zu einem annähernd exakten Ergebnis gelangen – die Genauigkeit der Messung über mehrere Quantisierungsstufen hinweg erhalten bleiben muss. Bei reibschlüssigem Antrieb über ein Gummituch liegt der Differenzdrehwinkel pro Umdrehung um zwei Zehnerpotenzen höher

$$(\frac{\Delta\varphi}{U} \leq |10^{-2}|)$$

als bei formschlüssigem Antrieb, wobei die langsame Zunahme zusätzlich einen über mehrere hundert Quantisierungsstufen reichenden Messbereich erfordert.

Bei einem anderen bekannten Messverfahren werden beispielsweise die beiden Impulsfolgen, d.h. die beiden Frequenzen mittels Frequenzspannungswandler in Spannungen umgewandelt und danach in einem Subtrahierer die Differenz zwischen den beiden Spannungswerten erzeugt. In einem nachgeschalteten Dividierer wird eine Quotientenbildung zwischen der ermittelten Spannungsdifferenz und einer Bezugsspannung vorgenommen, welche von einem der beiden Frequenzspannungswandler erzeugt wird. Da die verarbeiteten Spannungen Frequenzen entsprechen, liefert das Ausgangssignal nur die zeitliche Änderung des Differenzdrehwinkels

$$\frac{\Delta\varphi}{\varphi} = \frac{\Delta\omega}{\omega}.$$

Von Nachteil ist dabei, dass die Berechnung von

$$\frac{\Delta\varphi}{\varphi}$$

nur durch eine aufwendige Integration des analogen Signals möglich ist, ohne die eine konkrete Aussage über die momentane Winkellage der Zylinder gegenüber einem Ausgangszustand nicht möglich ist. Bei Untersuchungen nahe dem Gleichlauf, d.h. beim Auftreten geringer Differenzdrehwinkel

$$(\frac{\Delta\varphi}{U}<|10^{-2}|),$$

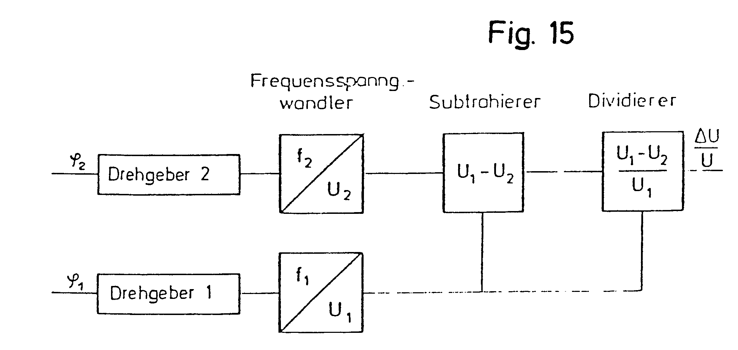

versagt dieses Verfahren vollständig, da die von den Frequenzspannungswandlern erzeugten Spannungen $U_1$ und $U_2$ in diesem Fall fast gleich gross sind und die Differenz der beiden nahezu Null ist. Ausgehend davon, dass die Frequenzspannungswandler systembedingt eine gewisse Restwelligkeit mit der Periode der umgesetzten Frequenz im Spannungssignal aufweisen, die grösser ist als der absolute Messwert, wird das Ausgangssignal nur noch durch diese Störung bestimmt, weshalb ein Nutzsignal selbst nicht mehr erkennbar ist (Fig. 15).

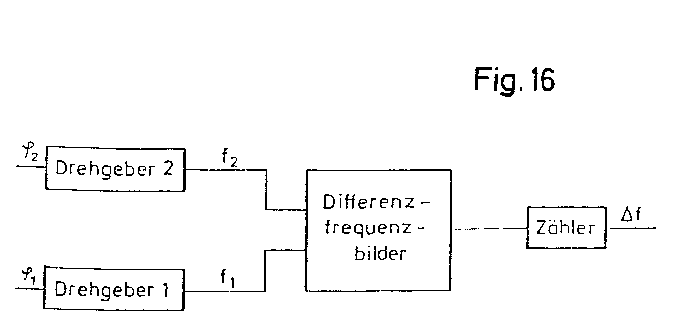

Ein in der Zeitschrift «Messen, Steuern, Regeln» 2/1981 auf den Seiten 98 bis 102 abgehandeltes neues Schlupfmessverfahren für die Antriebstechnik benutzt ebenfalls zwei, beispielsweise von inkrementalen, rotatorischen Gebern erzeugte Impulsfolgen bestimmter Frequenz. Mittels eines digitalen Mischers wird aus diesen beiden Impulsfrequenzen die Differenzfrequenz gebildet, welche direkt proportional ist der Differenzwinkelgeschwindigkeit $\Delta\varphi = \Delta\omega$. Im Gegensatz zum zuvor beschriebenen Messverfahren beinhaltet die Differenzfrequenz keine Vorzeicheninformation, so dass nicht festgestellt werden kann, ob eine vorhandene Übersetzung ins Schnelle oder ins Langsame geht. Ein weiterer Nachteil dieses Verfahrens besteht darin, dass die Richtungstendenz eines vorhandenen Differenzdrehwinkels überhaupt nicht und dessen absolute Grösse nur mittels aufwendiger Integration feststellbar ist. Bei einem Differenzdrehwinkel von

$$\frac{\Delta\varphi}{U}\leq|10^{-4}|$$

wird die Periode der Differenzfrequenz derart lang, dass eine Information erst nach einer oder mehreren Zylinderumdrehungen zur Verfügung steht (Fig. 16).

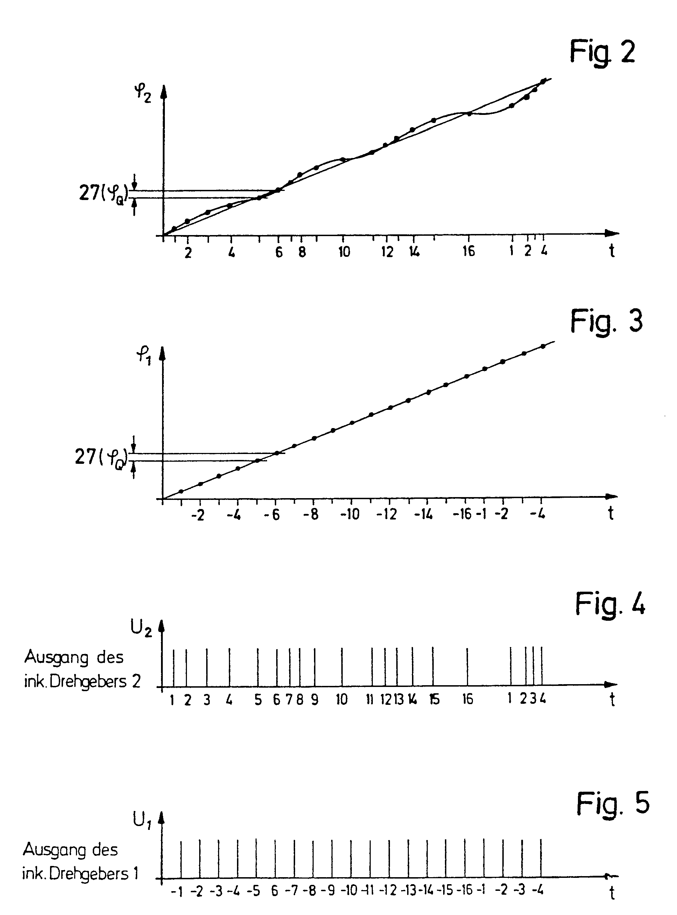

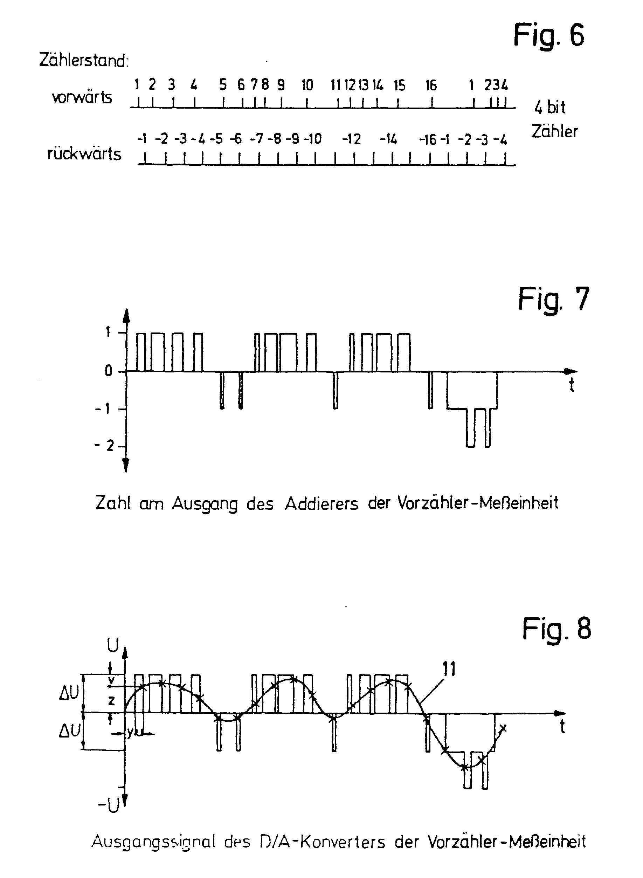

Die in der Abhandlung vorgeschlagene PLL-Regelschaltung, d.h. Vervielfachung der Differenzfrequenz, vermag hier keine Abhilfe zu schaffen, da deren Einschwingzeit ebenfalls mindestens eine Periode der Differenzfrequenz beträgt. Eine Vervielfachung der beiden Drehgeberimpulsfrequenzen vor dem Differenzfrequenzbilder, wie in den Figuren 2 und 6 der Abhandlung dargestellt, bringt zwar einerseits eine Erhöhung der resultierenden Differenzfrequenz, andererseits jedoch den Nachteil sehr hoher Impulsfrequenzen mit sich, da die Vervielfachung um den Faktor der Erhöhung vorgenommen werden muss. Diese hohen Impulsfrequenzen erreichen sehr schnell die Grenzfrequenz der elektronischen Bauteile, was zwangsweise eine Begrenzung der Drehzahl bedeutet.

Bei zwei weiteren, sich im Funktionsablauf weitaus gleichenden Verfahren, die aus der GB-A 1 439 553 und aus VDI-Z 122, Nr. 1/2, 1980, bekannt sind, werden die Impulse zweier Drehgeber zur Steuerung einer elektronischen Torschaltung verwendet, wobei die Impulse des ersten Drehgebers das Tor öffnen und mit den jeweils nachfolgenden Impulsen des zweiten Drehgebers dasselbe wieder geschlossen wird. Während der Toröffnungszeit wird eine Zahlimpulsfolge, die beispielsweise durch Frequenzvervielfachung aus einem der beiden Drehgeber gewonnen wurde, durchgelassen, wobei die durchgelassene Anzahl der Impulse proportional dem zwischen den Zylindern vorhandenen Differenzdrehwinkel ist. Da dies jedoch nur innerhalb einer Quantisierungsstufe gilt, kann der Differenzdrehwinkel $\Delta\varphi$, sobald er grösser als eine Quantisierungsstufe wird, nur durch eine komplexe und daher sehr aufwendige Rechnerauswertung gewonnen werden. Die Auflösung ist direkt proportional zum gewählten Vervielfachungsfaktor. Bei Zunahme der Drehzahl erreicht jedoch die generierte Frequenz – genau wie beim zuvor beschriebenen Verfahren – schon im niedrigen Drehzahlbereich die Grenzfrequenz der elektronischen Bauteile (Fig. 17). Der Anwendungsbereich der Einrichtung der GB-A 1 439 553 ist ausserdem auf zwei elektrische Impulsfolgen gleicher Frequenz beschränkt.

Ausgehend von diesem Stand der Technik besteht die Aufgabe der Erfindung darin, ein Messverfahren und eine Vorrichtung zur Durchführung desselben zu schaffen, mit denen sich die Phasenlage zweier vorzugsweise aus der Rotation zweier Rotationskörper gewonnener Impulsfolgen bzw. deren Phasenverschiebung sowohl innerhalb einer Quantisierung als auch über viele Quantisierungsstufen der Impulsgeber hinweg, unabhängig von der Impulsfrequenz bzw. der Drehzahl der Rotationskörper, mit absolut gleicher Genauigkeit exakt feststellen und in leicht weiterverarbeitbarer Form, vorzugsweise als Differenzdrehwinkel, anzeigen lässt.

Erfindungsgemäss wird diese Aufgabe bei einem Verfahren der eingangs genannten Gattung gelöst durch folgende Verfahrensschritte:

1. Aufteilung des Messbereiches zur Messbereichserweiterung in Abhängigkeit vom Phasenwinkel $\Delta\varphi$ in einem Vorzähler-Messbereich und Überlaufzähler-Messbereich,
2. Zählen der Impulsfolgen in je zumindest zwei verschiedenen Zählern einer Vorzähler-Messeinheit,

3. digitale Differenzbildung der beiden Zählerstände der Vorzähler-Messeinheit,

4. Wandlung des digitalen Differenzergebnisses der Vorzähler-Messeinheit in ein erstes Analogsignal,

5. Abfrage der Vorzähler-Messeinheit nach positivem oder negativem Überlauf,

6. bei Überlauf Erzeugung von entsprechenden Überlaufimpulsen,

7. bei Abgabe von Überlaufimpulsen Inversion des höchsten Bits am Addiererausgang der Vorzähler-Messeinheit,

8. Zählen der positiven Überlaufimpulse bzw. der negativen Überlaufimpulse in je zumindest zwei verschiedenen Zählern einer Überlaufzähler-Messeinheit,

9. digitale Differenzbildung der beiden Zählerstände der Überlaufzähler-Messeinheit,

10. Wandlung des digitalen Differenzergebnisses der Überlaufzähler-Messeinheit in ein zweites Analogsignal,

11. analoge Addition des ersten und zweiten Analogsignals zu einem dritten Analogsignal,

12. Dekodierung des dritten Analogsignales und

13. Anzeige des dekodierten dritten Analogsignales als Mass für die Phasenlage bzw. Phasenverschiebung.

Mit dieser Grundausführung des $\Delta \varphi$-Messverfahrens ist es möglich, den Differenzwinkel $\Delta \varphi$ erheblich feiner als eine Quantisierung aufzulösen, trotzdem $\Delta \varphi$ bei dieser Auflösung über mehrere Quantisierungen hinweg mit absolut gleicher Genauigkeit gemessen werden kann, wobei jedoch auch bei unzulässig niedrigen Frequenzen das Verfahren im ungünstigsten Fall immerhin noch mit der Genauigkeit der Quantisierung arbeitet. Der besondere Vorteil der Lösung gemäss dem kennzeichnenden Teil des Patentanspruches 1 besteht darin, dass das Verfahren insbesondere auch zur Messung extrem hoher Impulsfolgefrequenzen einsetzbar ist, wobei sich durch die Aufteilung des Messbereiches sogar eine Grenzfrequenz >1MHz erzielen lässt. Dabei bleibt die Genauigkeit des Messverfahrens jedoch unabhängig von der Höhe der Impulsfolgefrequenz. Das Vorzeichen des Differenzdrehwinkels $\Delta \varphi$ ist durch das Vorzeichen des dekodierten Analogsignales ausserdem von alleine gegeben, wobei die Dekodierung einfachheitshalber durch ein Tiefpassfilter erster Ordnung erfolgen kann.

Zwecks vorteilhafter Verarbeitung des $\Delta \varphi$ proportionalen Analogsignales, z.B. zur Bestimmung der Übersetzung von Antrieben oder zur Gleichlaufkontrolle zweier Antriebe besteht eine zusätzliche Ausgestaltung der $\Delta \varphi$-Messverfahren in folgenden Verfahrensschritten:

1. Erzeugung eines Abtastintervalles

2. Vorgabe und Speicherung des Abtastintervalles

3. Null-Setzung des Phasenwinkels zu Beginn des Abtastintervalles

4. Speicherung des während des Abtastintervalles aufgelaufenen Phasenwinkels

5. Erneute Null-Setzung des Phasenwinkels nach Ablauf des Abtastintervalles und

6. Anzeige des gespeicherten Phasenwinkels $\Delta \varphi$ pro Abtastintervall.

Bei einem weiteren Zusatzmessverfahren, das sich insbesondere zur Ermittlung der der Differenzwinkelgeschwindigkeit proportionalen Differenzfrequenz der Impulsfolgen eignet, wenn die Richtung der Differenzwinkelgeschwindigkeit systembedingt vorgegeben ist, wird das zur Anzeige vorgesehene, dem Differenzdrehwinkel $\Delta \varphi$ proportionale Analogsignal zur Frequenzbestimmung herangezogen. Die Erfindung betrifft weiters auch eine Vorrichtung zur Durchführung des beschriebenen Verfahrens, die in Anspruch 12 gekennzeichnet ist.

Weitere vorteilhafte Ausgestaltungen des Erfindungsgedankens und sich daraus ergebende Vorteile sind in der nachfolgenden Beschreibung sowie in den Ansprüchen 2 bis 4, 6 bis 8, 10 und 11 sowie 13 bis 21 enthalten.

Die Erfindung ist nachfolgend anhand eines in den Zeichnungen dargestellten $\Delta \varphi$-Grundmessverfahrens sowie zweier Zusatzmessverfahren näher erläutert. Es zeigt:

Fig. 1 den schematischen Aufbau einer Messvorrichtung zur Duchführung des $\Delta \varphi$-Grundmessverfahrens,

Fig. 2 bis 8 die Signalzustände bzw. Zustandsänderungen ausschliesslich in der Vorzähler-Messeinheit der Messvorrichtung gemäss Fig. 1 vor Aktivierung der Überlaufzähler-Messeinheit,

Fig. 9 bis 11 die Signalzustände bzw. Zustandsänderungen in der Messvorrichtung gemäss Fig. 1 bei Zusammenwirken der Vorzähler- und Überlaufzähler-Messeinheit für die Grenzfälle $\varphi_1(t) = 0$, und $\varphi_2(t) = 0$,

Fig. 12 den schematischen Aufbau einer Messvorrichtung zur Durchführung eines ersten Zusatzmessverfahrens,

Fig. 13 den schematischen Aufbau einer Messvorrichtung zur Durchführung eines zweiten Zusatzmessverfahrens,

Fig. 14 eine schaltungsmässige Variante von Fig. 13 und

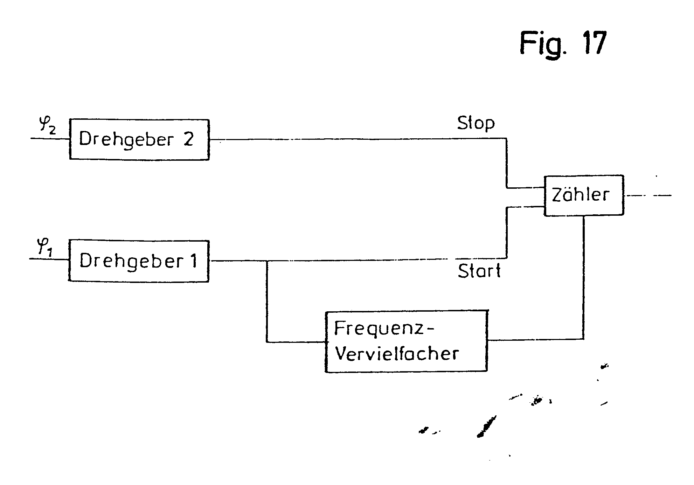

Fig. 15–17 Messeinrichtungen zum Stand der Technik.

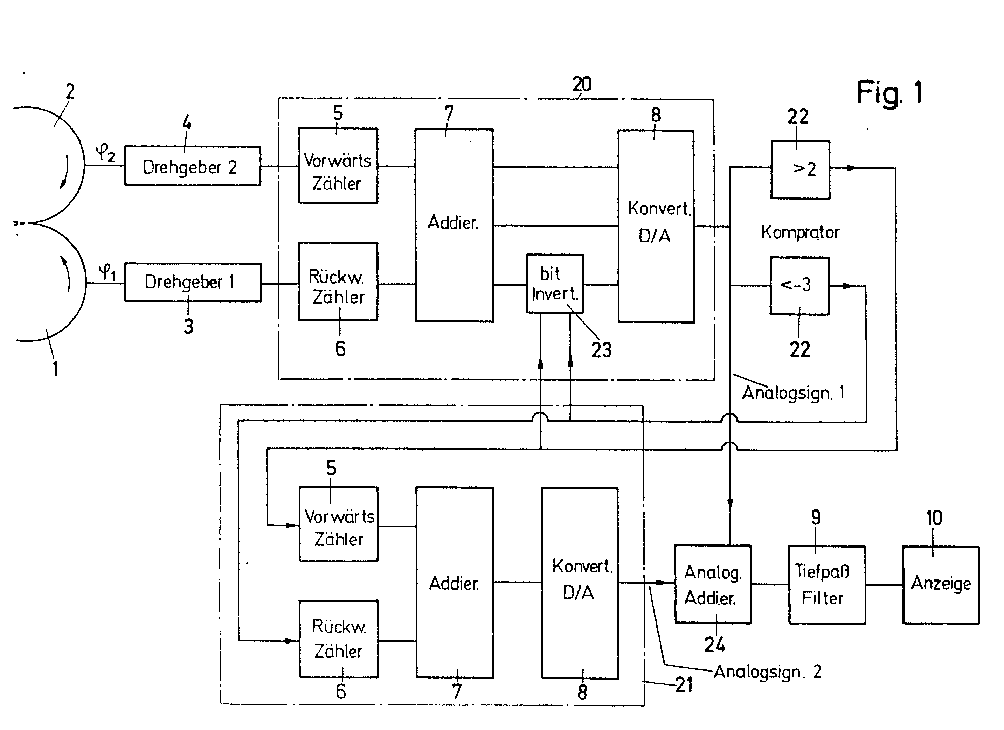

Gemäss den in Fig. 1 in Form des Aufbaus einer Messvorrichtung hardwaremässig dargestellten Verfahrensschritten wird der Messvorgang des Differenzdrehwinkels $\Delta \varphi$ bei dem $\Delta \varphi$-Grundmessverfahren in zwei Messbereiche, einen Vorzähler-Messbereich und einen Überlaufzähler-Messbereich aufgeteilt. Als erster Verfahrensschritt werden die Drehwinkel $\varphi_1$ und $\varphi_2$ zweier Rotationskörper 1 und 2 mittels zweier inkrementaler Drehgeber 3 und 4 gemessen und quantisiert. Dabei wird vorausgesetzt, dass die beiden Rotationskörper 1 und 2 ausreichende träge Massen aufweisen, die keine sprunghaften Änderungen der Drehwinkelgeschwindigkeit und damit des Differenzdrehwinkels $\Delta \varphi$ zulassen. Die

Unterteilung der Drehwinkel $\varphi_1$ und $\varphi_2$ in einzelne Winkelschritte 27 ist dabei abhängig von der vorhandenen Anzahl N der Inkremente auf den Codier- bzw. Impulsscheiben der beiden inkrementalen Drehgeber 3 und 4, wobei ein einzelner Winkelschritt 27 von Inkrement zu Inkrement

$$\varphi_Q = \frac{360}{N}$$

ist. Von jedem inkrementalen Drehgeber 3 bzw. 4 wird pro Winkelschritt 27 Impuls erzeugt.

Den inkrementalen Drehgebern 3 und 4 ist eine ausschliesslich als Vorzähler-Messeinheit 20 ausgebildete Baugruppeneinheit 5–8 nachgeschaltet, die dem Vorzähler-Messbereich zugeordnet ist. Dabei ist dem inkrementalen Drehgeber 4 ein Zähler 5 und dem inkrementalen Drehgeber 3 ein Zähler 6 nachgeschaltet. Die beiden Zähler 5 und 6 der Vorzähler-Messeinheit 20 fungieren ausschliesslich als Vorzähler und können entweder als zwei auf digitaler Basis arbeitende Vorwärtszähler, zwei Rückwärtszähler oder stattdessen als je ein Vorwärts- oder ein Rückwärtszähler ausgebildet sein. Während der Rotation der beiden Rotationskörper 1 und 2 werden die beiden von den inkrementalen Drehgebern 3 und 4 erzeugten Impulsfolgen in den beiden Zählern 5 und 6 gezählt, die in dem in Fig. 1 dargestellten Grundverfahren beispielhaft als Vorwärts-Digitalzähler 5 und Rückwärts-Digitalzähler 6 mit jeweils 4 Bit ausgebildet sind und somit eine Zählkapazität von 1 bis 16 aufweisen. Da die Impulsfolgen jedoch eine wesentlich höhere Zahl liefern, läuft der Vorwärts-Digitalzähler 5 beim Erreichen der Zahl 16 über, beginnt wieder bei der Zahl 1, zählt weiter bis zur Zahl 16 usw. Der Rückwärts-Digitalzähler 6 verhält sich in entsprechender Weise. Wenn bei der Messung nicht der Drehwinkel $\varphi$, sondern der Differenzwinkel $\Delta \varphi$ gesucht wird, spielt das Überlaufen der Zähler keine Rolle.

Die beiden Digitalzähler 5 und 6 sind mit einem gemeinsamen Differenzbilder 7 verbunden, der in Abhängigkeit von der Art der verwendeten Rechner als digitaler Addierer oder digitaler Subtrahierer ausgebildet sein kann. Der beim $\Delta \varphi$-Grundmessverfahren eingesetzte digitale Addierer 7 bildet nur mittels Addition der Zählerstände der beiden Digitalzähler 5 und 6 die Differenz zwischen den einlaufenden Impulsen, wobei die Zahl am Ausgang des digitalen Addierers 7 den Ausgang ohne Überlauf-Bit darstellt. Der maximal messbare Differenzdrehwinkel $\Delta \varphi$ max wird durch die Kapazität der Digitalzähler 5 und 6 sowie des digitalen Addierers 7 begrenzt. Beim alternativen Einsatz von jeweils zwei Vorwärtsoder zwei Rückwärtszählern ist der Differenzbilder 7 als digitaler Subtrahierer ausgebildet, der die Differenzbildung der beiden Zählerstände mittels digitaler Subtraktion durchführt.

Der Ausgang des digitalen Addierers 7 ist mit einem Digital/Analog-Konverter 8 verbunden. Dieser ist als extrem schneller, über z.B. 3 Bit arbeitender Konverter ausgebildet.

Durch die eingangs erwähnte Aufteilung des Messbereiches in einen Vorzähler- sowie einen Überlaufzähler-Messbereich bedingt, ist die Vorzähler-Messeinheit 20 mittels eines zwischengeschalteten Analog-Komparators 22 mit einer nachgeschalteten Überlaufzähler-Messeinheit 21 gekoppelt, bei der die elektronischen Bauelemente 5 bis 8 der Vorzähler-Messeinheit 20 ebenfalls Anwendung finden und auch in gleicher Reihenfolge angeordnet sind. Im einzelnen handelt es sich hierbei um die beiden Digitalzähler 5 und 6, den digitalen Addierer 7, sowie den nachgeschalteten Digital/Analog-Konverter 8. Die Digitalzähler 5 und 6 der Überlaufzähler-Messeinheit 21 fungieren ausschliesslich als Überlaufzähler und treten mit dem, mit über z.B. 12 Bit arbeitenden Digital/Analog-Konverter 8 der Überlaufzähler-Messeinheit 21 nur bei Überlauf der Vorzähler-Messeinheit 20 in Aktion.

Zwischen dem das höchstwertige Bit übertragenden Ausgang des digitalen Addierers 7 der Vorzähler-Messeinheit 20 und dem diesem nachgeordneten schnellen Digital/Analog-Konverter 8 ist ein Bit-Invertierer 23 zwischengeschaltet, der mit dem Analog-Komparator 22 gekoppelt ist und von diesem gesteuert wird. Der Bit-Invertierer 23 besteht aus einem JK-Flipflop mit nachgeschaltetem Exklusiv-ODER-Gatter, kurz Exor genannt. Beiden Digital/Analog-Konvertern 8 der Vorzähler-Messeinheit 20 und der Überlaufzähler-Messeinheit 21 ist ein gemeinsamer Analogaddierer 24 nachgeschaltet, der mit dem Tiefpassfilter 9 verbunden ist. Das Tiefpassfilter 9 ist mit der Anzeigevorrichtung 10 gekoppelt, die die Schaltung für das $\Delta \varphi$-Grundmessverfahren abschliesst.

Anhand der Figuren 2 bis 8 können die auftretenden Signale des $\Delta \varphi$-Grundmessverfahrens für den Fall verfolgt werden, wenn aufgrund geringer $\Delta \varphi$-Schwankung ausschliesslich die Vorzähler-Messeinheit 20 aktiviert ist und die Überlaufzähler-Messeinheit 21 ihre Arbeit noch nicht aufgenommen hat. Es wird darauf hingewiesen, dass es sich bei den in der nachfolgenden Beschreibung dieser Figuren erwähnten elektronischen Beuteilen 5 bis 8 ausschliesslich um die der Vorzähler-Messeinheit handelt.

In den Figuren 2 und 3 sind die Drehwinkel $\varphi_2$ und $\varphi_1$ als Funktion der Zeit t quantisiert in einzelne Winkelschritte $\varphi_Q$ (Quantisierungsstufe 27) dargestellt. Das Diagramm der Figur 2 zeigt die tatsächlich durch die Ungleichmässigkeit des Antriebes, z.B. infolge Verzahnungsfehlern vorkommenden physikalischen Grössen auf, wobei die Nichtlinearität der Drehwinkelkurve durch teilweises Voreilen und teilweises Nacheilen des Drehwinkels $\varphi_2$ bedingt ist.

Aufgrunddessen variieren die Zeitspannen zwischen den einzelnen Quantisierungsstufen 27. Beim Diagramm der Fig. 3 mit linear ansteigendem Kurvenverlauf des Drehwinkels $\varphi_1$ wurde angenommen, dass der Antrieb gleichförmig ist und der Drehwinkel $\varphi_1$ linear mit der Zeit t zunimmt. Dadurch bleiben die Zeitspannen zwischen den einzelnen Quantisierungsstufen 27 jeweils konstant.

In den Figuren 4 und 5 sind die von den inkrementalen Drehgebern 3 und 4 ausgegebenen Impulse bzw. Impulsfolgen, ausgedrückt in Spannungswerten $U_2$ und $U_1$, als Funktion der Zeit t dargestellt. In Abhängigkeit von der Nichtlinearität des Drehwinkels $\varphi_2$ ergibt sich beim Impulsdiagramm der Fig. 4 eine zeitliche Unregelmässigkeit der Impulsfolge, währenddessen beim Impulsdiagramm der Fig. 5 gemäss der Linearität des Drehwinkels $\varphi_1$ die Zeitspanne zwischen den einzelnen Impulsen unverändert bleibt.

In Fig. 6 sind symbolisch die Zählerstände der beiden Digitalzähler 5 und 6 real in Digitalzahlen dargestellt. Während die obere Zahlenfolge der Fig. 6 den Zählerstand des Vorwärts-Digitalzählers 5 veranschaulicht, zeigt die untere den des Rückwärts-Digitalzählers 6 auf. Da die Digitalzähler 5 und 6, wie bereits zuvor erläutert, beispielhaft als 4 Bit-Zähler ausgebildet sind, laufen diese beim Erreichen der Zahl 16 über und beginnen wieder bei der Zahl 1 von neuem zu zählen.

Im Stufendiagramm der Fig. 7 ist der digitale Zahlenwert veranschaulicht, welcher sich aus der digitalen Addition der Zählerstände der beiden Digitalzähler 5 und 6 ohne Überlauf-Bit ergibt und folglich am Ausgang des digitalen Addierers 7 anliegt. Dabei sind jedem der an der Ordinate aufgetragenen Zahlenwerte jeweils bestimmte Spannungswerte zugeordnet. Bei der Zahl 1 des Vorwärts-Digitalzählers 5 führt der Ausgang des digitalen Addierers 7 den digitalen Zahlenwert 1, der solange anhält, bis die Zahl –1 des Rückwärts-Digitalzählers 6 digital addiert wird. In diesem Moment sinkt der Zahlenwert am Ausgang des Digitaladdierers 7 auf den Wert 0, der wiederum solange anhält, bis die Zahl 2 des Digital-Vorwärtszählers 5 addiert wird. Am Ausgang des Addierers liegt nun eine 1 an, bis wiederum die −2 des digitalen Rückwärtszählers 6 addiert wird, usw.

In Fig. 8 sind sowohl die Ausgangssignale des Digital/Analog-Konverters 8 als auch die Ausgangssignale des beiden Messeinheiten 20 und 21 nachgeschalteten Tiefpassfilters 9, beide als Spannungswerte U, in Abhängigkeit von der Zeit t veranschaulicht. Aufgrund der inaktiven Überlaufzähler-Messeinheit 21 ist das Ausgangssignal des Digital/Analog-Konverters 8 identisch mit dem des Analogaddierers 24. Die Ausgangssignale des Digital/Analog-Konverters 8 entsprechen wertmässig dem Stufendiagramm gemäss Fig. 7, jedoch mit dem Unterschied, dass dessen Zahlenwerte nur in Spannungsstufen umgesetzt sind. Das Analogsignal am Ausgang des Digital/Analog-Konverters 8 springt entsprechend der anliegenden Impulsdifferenzzahl am Ausgang des digitalen Addierers 7. Die Information über den Differenzdrehwinkel $\Delta \varphi$ steckt nun für jede Quantisierung der Bezugsimpulsfolge im Tastverhältnis

$$\frac{u}{y} = \frac{v}{z}$$

und in der Spannungsstufe des Ausgangssignales des Digital/Analog-Konverters 8. Da sich der Differenzdrehwinkel $\Delta \varphi$, wie bereits erwähnt, durch die trägen Massen der beiden Rotationskörper 1 und 2 nicht sprunghaft ändert, kann aus den einzelnen Werten ein kontinuierlicher Verlauf des Differenzdrehwinkels $\Delta \varphi$ erzeugt werden.

Die im Tastverhältnis und in den Spannungsstufen in codierter Form enthaltenen einzelnen Werte des Differenzdrehwinkels $\Delta \varphi$ werden im Tiefpassfilter 9 durch Dekodierung zu einem kontinuierlichen, analogen Signal des Differenzdrehwinkels $\Delta \varphi$ umgeformt, welches in Fig. 8 als sinusförmige Spannungskurve 11 dargestellt ist. Durch diese Dekodierung wird eine Auflösung des Differenzdrehwinkels $\Delta \varphi$ erreicht, die viel feiner ist als eine Quantisierungsstufe 27 der inkrementalen Drehgeber 3 und 4.

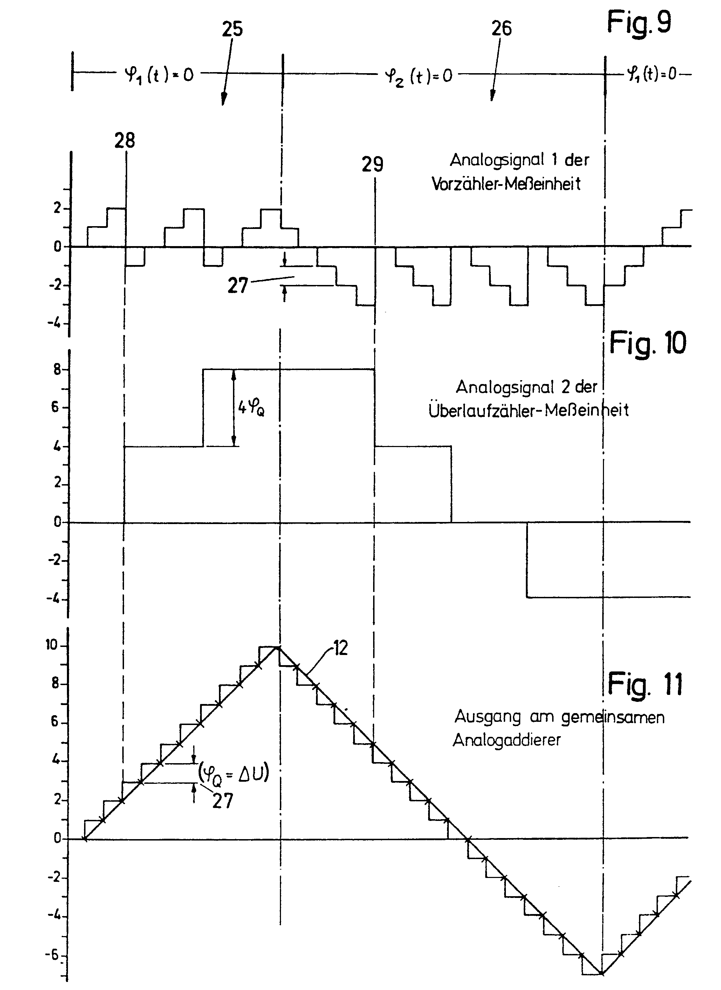

In den Diagrammen der Figuren 9–11 ist das Zusammenwirken von Vor- und Überlaufzähler-Messeinheit 20 und 21 am Beispiel für die beiden Grenzfälle $\varphi_1(t) = 0$ und $\varphi_2(t) = 0$ dargestellt. Dadurch ist das Verhalten bei positivem und negativem Überlauf der beiden Digitalzähler 5 und 6 der Vorzähler-Messeinheit 20 erkennbar. In der nachfolgenden Wahrheitstabelle wird die interne Zahlendarstellung der beispielsweise als 3 Bit-Zähler ausgelegten Digitalzähler 5 und 6 der Vorzähler-Messeinheit 20 aufgezeigt.

| | |
|---|---|
| | LLL 3 |
| | LLO 2 |
| | LOL 1 |
| Wahrheitstabelle | LOO 0 |
| | OLL –1 |
| | OLO –2 |
| | OOL –3 |
| | OOO –4 |

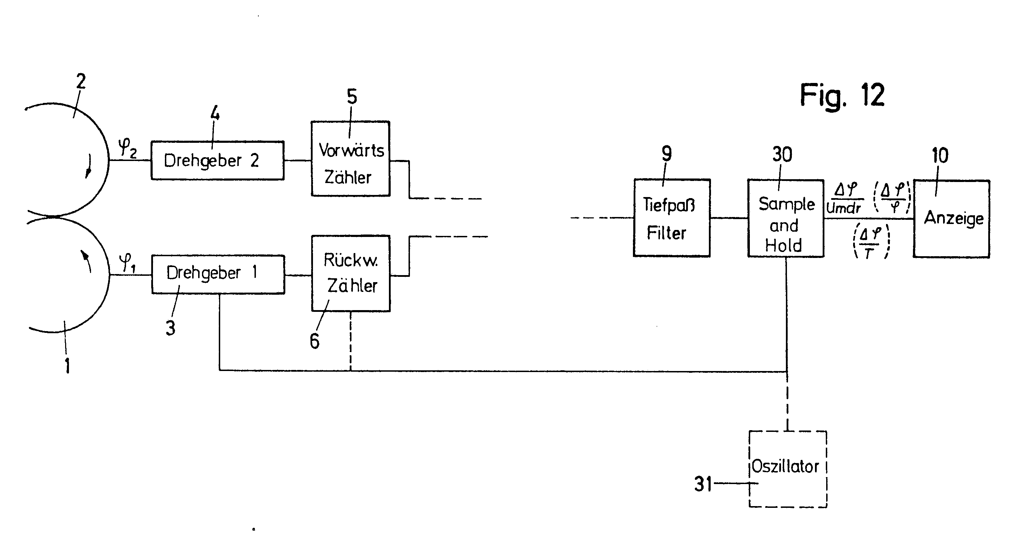

Im Stufendiagramm der Fig. 9 ist das am Ausgang der Vorzähler-Messeinheit 20 anstehende erste Analogsignal dargestellt, unter der Annahme, dass in der ersten, mit der Bezugsziffer 25 gekennzeichneten Kurvenhälfte $\varphi_1(t) = 0$ und in der zweiten Kurvenhälfte 26 $\varphi_2(t) = 0$ ist. Beginnt die Messung mit einem Differenzdrehwinkel $\Delta \varphi = 0$ und ist die Schwankungsbreite von geringer als vier Quantisierungsstufen 27, so arbeitet ausschliesslich der Vorwärts-Digital-Zähler 5 der Vorzähler-Messeinheit 20 gemäss der Signaldarstellung in der ersten Kurvenhälfte 25. Aufgrunddessen steht am Ausgang der Überlaufzähler-Messeinheit 21 während dieser Zeit kein zweites Analogsignal an, so dass deren Ausgang den Analogwert 0 führt (Fig. 10). Auch am Ausgang des gemeinsamen Analog-Addierers 24 liegt dann gemäss Fig. 11 ausschliesslich der Wert des ersten Analogsignales der Vorzähler-Messeinheit 20 an, und zwar so lange, bis der Vorwärts-Digitalzähler 5 der Überlaufzähler-Messeinheit 21 mit seiner Zählarbeit beginnt.

Pro Quantisierungsstufe 27 zählt der Vorwärts-Digitalzähler 5 der Vorzähler-Messeinheit 20 eins höher, bis er gemäss Wahrheitstabelle bei LLO auf 2 angelangt ist. Wird der Differenzdrehwinkel $\Delta \varphi$ in positiver Richtung grösser als zwei Quantisierungsstufen 27, so springt der Vorwärts-Digitalzähler 5 – welcher nur als 3 Bit-Zähler ausgebildet ist – gemäss Wahrheitstabelle bei LLL auf –1 = OLL um, da gesteuert vom Analog-Komparator 22, das höchste Bit des digitalen Addierers 7 der Vorzähler-Messeinheit 20 durch den Bit-Invertierer 14 invertiert wird. Dadurch liegt am Ausgang des Digital/Analog-Konverters 8 der Vorzähler-Messeinheit 20 nicht der logische Zahlenwert 3, sondern stattdessen der Wert –1 an.

Gleichzeitig mit der Bit-Inversion durch den Bit-Invertierer 23 wird ein Impuls an den Vorwärts-Digitalzähler 5 der Überlaufzähler-Messeinheit 21 abgegeben. Da dieser nur in Vierer-Stufen zählt, hat ein derartiger Impuls im Überlauf den Wert 4 auf der Analogseite des Digital/Analog-Konverters 8 der Überlaufzähler-Messeinheit 21 zur Folge, wie im Diagramm der Figur 10 dargestellt, dass das am Ausgang der Überlaufzähler-Messeinheit 21 anstehende zweite Analogsignal aufzeigt.

Der Zustand innerhalb der Messvorrichtung hat sich demnach an dem in den Figuren 9 bis 11 mit der Bezugsziffer 28 gekennzeichneten Inversionsprung vom Wert 2 im Vorwärts-Digitalzähler 5 der Vorzähler-Messeinheit 20 auf den Wert –1 und von dem Wert 0 im Vorwärts-Digitalzähler 5 der Überlaufzähler-Messeinheit 21 auf den Wert 4 verändert. Durch die analoge Addition des ersten Analogsignales der Vorzähler-Messeinheit 20 mit dem zweiten Analogsignal der Überlaufzähler-Messeinheit 21 liegt somit am Ausgang des gemeinsamen Analogaddierers 24 gemäss dem in Fig. 11 dargestellten Stufendiagramm der analoge Zahlenwert 3 an, wobei jedem in diesem Diagramm dargestellten Zahlenwert ein bestimmter Spannungswert bzw. jeder Quantisierungsstufe eine entsprechende Spannungsdifferenz zugeordnet ist.

Für den Fall, dass sich die Richtung des Differenzdrehwinkels $\Delta\varphi$ gemäss Darstellung in der zweiten Kurvenhälfte 26 der Fig. 9 unter der Annahme $\varphi_2(t) = 0$ ändert, zählt der Rückwärts-Digitalzähler 6 der Vorzähler-Messeinheit 20 vom momentanen Zustand, z.B. 2, rückwärts bis –3. Wird dieser Wert überschritten, so wird – ebenfalls gesteuert vom Analogkomparator 22 – das höchste Bit des digitalen Addierers 7 der Vorzähler-Messeinheit 20 durch den Bit-Invertierer 23 invertiert. Da der Wert –4 instabil ist und gemäss Wahrheitstabelle vom Zustand 000 wieder auf den Wert 0 = L00 springt, liegt am Ausgang des Digital/Analog-Konverters 8 der Vorzähler-Messeinheit 20 nicht der Wert –4 an, sondern der Wert 0 an.

Gleichzeitig mit dem Rückspringen des Rückwärts-Digitalzählers 6 der Vorzähler-Messeinheit 20 auf den Wert 0 wird ein Impuls an den Rückwärts-Digitalzähler 6 der Überlaufzähler-Messeinheit 21 gegeben, wodurch der Rückwärts-Digitalzähler 6 der Überlaufzähler Messeinheit 21 einen 4-Stufensprung macht und am Analogausgang des Digital/Analog-Konverters 8 der Überlaufzähler-Messeinheit 21 der Wert bei dem in den Figuren 22 bis 24 mit der Bezugsziffer 29 gekennzeichneten Inversionsprung gleichzeitig um 4 sinkt. Dadurch ist der Wertsprung von –4 auf 0 am Analogausgang des Digital/Analog-Konverters 8 der Vorzähler-Messeinheit 20 bei der nachfolgenden analogen Endaddition wieder ausgeglichen. Aus dem Wert von z.B. –3 der Vorzähler-Messeinheit 20 und dem Wert 8 der Überlaufzähler-Messeinheit 21, d.h. dem Summenwert 5, wird dann in der Vorzähler-Messeinheit 20 durch Bit-Inversion der Wert 0 und in der Überlaufzähler-Messeinheit 21 der Wert 4. Die analoge Addition dieser beiden Signalwerte ergibt gemäss der zugehörigen Spannungsstufe im Stufendiagramm der Fig. 11 den Summenwert 4.

Durch diese Zählweise wird erreicht, dass die Überlaufzähler-Messeinheit 21 mit dem langsameren, über z.B. 12 Bit arbeitenden Digital/Analog-Konverter 8 wesentlich seltener ihren Zustand verändern muss, während die Vorzähler-Messeinheit 20 mit dem extrem schnell arbeitenden Digital/Analog-Konverter 8 die Hauptarbeit übernimmt. Ein gleichzeitiger Wechsel von sehr vielen Bit-Stellen, z.B. für 12 Bit von LOOOOOOOOOOO auf OLLLLLLLLLLL und umgekehrt, mit der Impulsfolgefrequenz und die dadurch bedingte lange Einschwingzeit wird durch die Vorzähler-Messeinheit 20 vermieden, da die Zählarbeit auf beide Zähler-Messeinheiten 20 und 21 aufgeteilt ist.

Sobald die Überlaufzähler-Messeinheit 21 in Aktion getreten ist, liegt die zu messende Grenzfrequenz erheblich höher als bei alleiniger Zählarbeit durch die Vorzähler-Messeinheit 20. Die nachfolgende Decodierung des am Ausgang des gemeinsamen Analogaddierers 24 anstehenden Analogsignales ist natürlich abhängig von der Filtercharakteristik des angewandten Tiefpassfilters 9. Vorzugsweise kann hierzu ein einfaches Tiefpassfilter erster Ordnung verwendet werden. Das decodierte und gemittelte Ausgangssignal des Tiefpassfilters 9 bei einem Verhalten $\varphi_1(t) = 0$ und $\varphi_2(t) = 0$ ist in Fig. 11 zusammenhängend dargestellt mit der Bezugsziffer 12 gekennzeichnet.

Nach der Bestimmung des Differenzdrehwinkels $\Delta\varphi$ kann eine Weiterverarbeitung $\Delta\varphi$ proportionalen Analogsignales angebracht sein, um die Differenzwinkelgeschwindigkeit $\Delta\varphi$, den pro Umdrehung pro Winkel, bzw. pro Zeiteinheit aufgelaufenen Differenzdrehwinkel

$$\frac{\Delta\varphi}{U}, \frac{\Delta\varphi}{\varphi},$$

bzw.

$$\frac{\Delta\varphi}{T}$$

zu ermitteln, insbesondere zur Bestimmung der Übersetzung von Antrieben. Hierzu ist ein erstes Zusatzmessverfahren vorgesehen, das sich zur Kombination sowohl mit dem $\Delta\varphi$-Grundmessverfahren, dem modifizierten $\Delta\varphi$-Grundmessverfahren, als auch mit dem zweiten $\Delta\varphi$-Messverfahren eignet. Der Schaltungsaufbau dieses ersten Zusatzmessverfahrens ist in Fig. 12 dargestellt.

Wie aus dieser Figur ersichtlich, ist zwischen dem Tiefpassfilter 9 und der Anzeigevorrichtung 10 zusätzlich ein taktgesteuertes Speicherglied 30 zwischengeschaltet, das vorzugsweise als Sample and Hold-Baustein ausgebildet ist. Die Taktsteuerung des Speichergliedes 30 kann auf dreifache Art erfolgen:

1. Durch die einmal pro Umdrehung abgegebenen Null-Impulse der inkrementalen Drehgeber 3 und 4. In diesem Fall ist der Sample and Hold 30 mit einem inkrementalen Drehgeber 3 bzw. 4 gekoppelt. Man erhält somit einen umdrehungsabhängigen Takt.

2. Die Taktung kommt von den digitalen Zählern 5 und 6. Jedesmal wenn eine binäre Zahl z.B. 2, 4, 16 usw. überschritten wird, gibt einer der beiden Digitalzähler 5 bzw. 6 einen Takt ab. In diesem Fall muss der Sample and Hold 30 mit Rücksetzeingängen der beiden Digitalzähler 5 und 6 rückgekoppelt sein. Man erhält dadurch einen winkelabhängigen Takt.

3. Durch Vorgabe einer festen Frequenz als Zeittakt, erzeugt durch ein separates Zeitglied 31. In diesem Fall ist der Sample and Hold 30 mit dem separaten Zeitglied 31 gekoppelt, welches vorzugsweise als quarzgesteuerter Oszillator ausgebildet ist. Man erhält somit einen zeitabhängigen Takt.

Das erste Zusatzmessverfahren wird nachfolgend beispielhaft an Hand der Taktung durch den inkrementalen Drehgeber 3 beschrieben, da die Taktung mittels eines der Digitalzähler 5 bzw. 6 sowie des quarzgesteuerten Oszillators 31 in Fig. 12 nur schematisch angedeutet sind. Durch die Takterzeugung mittels des inkrementalen Drehgebers 3 wird im taktgesteuerten Speicherglied 30 der pro Umdrehung der Rotationskörper 1 und 2 entstandene Differenzdrehwinkel

$$\frac{\Delta \varphi}{U}$$

festgehalten, d.h. es wird die Veränderung des Differenzdrehwinkels $\Delta \varphi$ bezogen auf einen zurückgelegten Drehwinkel des Zylinders 1 gespeichert. Dem gesuchten Ergebnis entspricht also die Steigung der Funktion $\Delta \varphi(\varphi_1)$ über einen Bereich von $\varphi_1 = 360°$.

Zur Realisierung wird aus dem Rückwärts-Digitalzähler 6 nach N-Strichzahlen des inkrementalen Drehgebers 3 ein Impuls abgeleitet und dem Sample and Hold 30 zugeführt. Ebensogut kann, wie zuvor unter Punkt 2 erwähnt, der in den inkrementalen Drehgebern 3 bzw. 4 vorhandene sogenannte Null-Impuls verwendet werden, der einmal pro Umdrehung erzeugt und ebenfalls dem Sample and Hold 30 abgegeben wird. Der Sample and Hold 30 speichert den im Zeitpunkt des Impulses vorhandenen $\Delta \varphi$-Wert bis zum Eintreffen des nächsten Impulses. Da gleichzeitig jedesmal die Digitalzähler 5 und 6 wieder auf Null gesetzt werden, läuft der $\Delta \varphi$-Wert jedesmal aufs Neue vom Wert Null ab. Daher stellt das Ausgangssignal des Sample and Hold 30 direkt ein

$$\frac{\Delta \varphi}{U}$$

proportionales Signal dar.

Selbstverständlich kann anstelle des Wertes $\varphi_1 = 360°$ jeder beliebige Winkelwert gewählt werden, ebenso wie anstelle des Winkels $\varphi_1$ die Zeit als Basis (quarzgesteuerte Periode T) gewählt werden kann, wobei in diesem Fall, wie unter Punkt 3 zuvor angedeutet, das Signal dann

$$\frac{\Delta \varphi}{\varphi} = \Delta \omega$$

proportional ist.

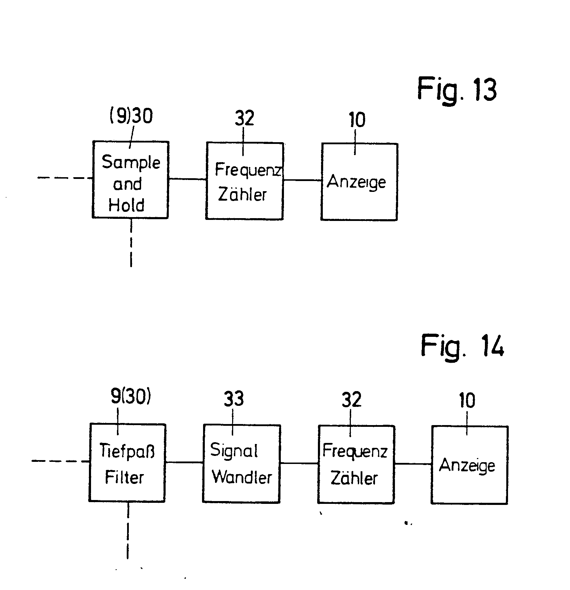

Ein zweites Zusatzmessverfahren, dessen Verfahrensschritte sich zur Kombination mit allen zuvor erwähnten Messverfahren und deren Abwandlungen eignet, sieht gemäss den Figuren 13 und 14 vor, dass das gefilterte, zur Anzeige vorgesehene, $\Delta \varphi$ proportionale Analogsignal zur Frequenzbestimmung herangezogen wird, so dass auch die der Differenzwinkelgeschwindigkeit $\Delta \dot\varphi = \Delta \dot\varphi$ proportionale Differenzfrequenz der Impulsfolgen ermittelt werden kann. Dies erscheint immer dann sinnvoll, wenn die Richtung der Differenzwinkelgeschwindigkeit $\Delta \omega$ systembedingt vorgegeben ist.

Wie in Fig. 13 dargestellt, kann die Realisierung dieses Zusatzmessverfahrens zur Frequenzbestimmung derart erfolgen, dass der Anzeigevorrichtung 10 direkt ein Frequenzzähler 32 vorgeschaltet ist, auf den das $\Delta \varphi$ proportionale Analogsignal gelegt wird. Dieser zählt jeweils bei Überschreiten eines bestimmten Spannungspegels, wodurch die Überlauffrequenz pro Zeiteinheit festgehalten wird. Eine andere Möglichkeit besteht gemäss Fig. 14 darin, dass das $\Delta \varphi$ proportionale Analogsignal in einem Signalwandler 33, vorzugsweise einem Schmitt-Trigger in ein Rechteck-Signal umgeformt und anschliessend im Frequenzzähler 32, durch Zählung der Überläufe bzw. durch Zählung der Schwellwertüberschreitungen die Überlauffrequenz pro Zeiteinheit bestimmt wird.

Das neue $\Delta \varphi$-Messverfahren kann nicht nur zur Bestimmung der Übersetzung einzelner Antriebmechanismen, sondern in vorteilhafter Weise auch zu Messungen in anderen technischen Bereichen verwendet werden. Insbesondere dann, wenn zwei nahezu gleich schnelle Bewegungen rotativer und/oder translativer Art quantisiert werden und die Lage bzw. die Veränderung der Lage der Quantisierungen zueinander gesucht ist, wird dieses Verfahren von besonderem Interesse sein.

Zur Kontrolle der Verzahnungsqualität wird heute vielfach die Einflankenwälzprüfung benutzt. Mit den heutigen Verfahren ist dies nur bei extrem langsamer Drehzahl möglich. Ausserdem wird hierfür eine komplexe Rechnerschaltung benötigt. Mit dem neuen Verfahren kann die Lage der Zahnräder zueinander und damit die Momentanübersetzung im gesamten Drehzahlbereich untersucht werden. Die Messeinrichtung ist trotz besserer Auflösung einfacher und billiger. Eine Gesamtkontrolle der in der Maschine eingebauten Verzahnung rückt daher in den Rahmen wirtschaftlicher Möglichkeiten. Für diese Anwendung können neben dem $\Delta\varphi$-Grundmessverfahren sehr gut auch das modifizierte Grundmessverfahren sowie die Zusatzmessverfahren benutzt werden.

Weitere Anwendungen ergeben sich, wenn die Drehwinkeländerung bezogen auf einen zurückgelegten Drehwinkel

$$\frac{\Delta\varphi}{\varphi}$$

gesucht ist. Bei Reibradgetrieben bzw. Schmitzringen in Offsetdruckmaschinen wird auch die vorgegebene Übersetzung i = 1, d.h. gleich grosse Durchmesser, bedingt durch die Fertigtoleranz nicht exakt erreicht. Zur Bestimmung der tatsächlichen Übersetzung muss die Differenz der aufeinander abrollenden Umfänge ermittelt werden. Da diese Abweichung, bezogen auf eine Umdrehung

$$< |10^{-4}|$$

ist, ist eine schnelle zuverlässige Messung erst durch das neue, innerhalb einer Quantisierung auflösende $\Delta\varphi$-Messverfahren möglich. Da ausserdem festgestellt werden kann, ob durch die Fertigungstoleranz eine Reibradübersetzung ins Schnelle oder ins Langsame entstanden ist, wird eine bisher nicht erreichbare, qualitätsfördernde Auslese der Reibradgetriebe für den Einbau in die Maschine möglich.

Eine weitere Anwendung bezüglich Winkelveränderung pro Winkel ergibt sich bei der Messung der Elastizitätskonstanten einer laufenden Papierbahn. Hierzu sind wie beim Zugversuch zwei Zustände unterschiedlicher Spannung notwendig. Neben der Spannungsdifferenz $\Delta\sigma$ muss die zwischen beiden Zuständen entstandene Dehnung

$$\varepsilon = \frac{\Delta l}{l}$$

gemessen werden. Entsprechend muss in der Papierbahn das Verhältnis

$$\frac{\Delta v}{v}$$

gemessen werden. Durch Elimination der Zeit kann

$$\frac{\Delta v}{v}$$

in

$$\frac{\Delta\varphi}{\varphi}$$

umgewandelt werden. Dieser Wert kann mit dem neuen $\Delta\varphi$-Messverfahren bestimmt werden. In dem speziellen Fall der E-Modul-Messung haben alle bisherigen Verfahren versagt, da die Differenzgeschwindigkeit um einen Faktor $10^{-4}$ kleiner ist als die Bezugsbahngeschwindigkeit, die Differenzgeschwindigkeit jedoch trotzdem mit einer Genauigkeit von 4 Stellen bestimmt werden muss. Erst die direkte Messung des Differenzdrehwinkels $\Delta\varphi$ ermöglicht diese Genauigkeit.

Zur Erzielung des Gleichlaufs zweier Motoren bzw. zwischen zwei von je einem Motor angetriebenen Rotoren ist zur Regelung die momentane Abweichung von der Phase, d.h. der Differenzwinkel als Information erforderlich. Mit den bisherigen Verfahren ist ein Gleichlauffehler von $\pm$ einer Quantisierung des Winkels erreicht worden. Da mit dem neuen Verfahren der Differenzwinkel praktisch in Echtzeit mit fast absoluter Genauigkeit gemessen werden kann, ist jede Änderung der Winkellage nicht nur in ihrer Grösse, sondern auch in ihrer Tendenz messbar.

Sollen z.B. zwei Druckwerke über eine elektrische Welle verbunden werden, so muss der dazu gehörende Motorregelkreis zur Erfüllung des drucktechnisch notwendigen Gleichlaufes die beiden Druckwerke so extrem phasenstarr antreiben, wie dies mit den bisherigen Verfahren nicht möglich ist. Dazu ist eine höchstgenaue Aussage über die Lage und die Änderung der Phase bzw. des Differenzdrehwinkels $\Delta\varphi$ unabhängig von der Drehzahl notwendig. Diese Aufgabe kann durch das neue $\Delta\varphi$-Messverfahren in einfacher Weise gelöst werden.

**Patentansprüche**

1. Verfahren zur hochgenauen Messung der Phasenlage bzw. Phasenverschiebung zweier Impulsfolgen, bei dem beispielsweise die Drehwinkel zweier Rotationskörper quantisiert, durch inkrementale Drehgeber in Impulsfolgen umgewandelt und diese zur Ermittlung der Phasenlage bzw. der Phasenverschiebung herangezogen werden, gekennzeichnet durch folgende Verfahrensschritte:

1. Aufteilung des Messbereiches zur Messbereichserweiterung in Abhängigkeit vom Phasenwinkel $\Delta\varphi$ in einen Vorzähler-Messbereich und Überlaufzähler-Messbereich,
2. Zählen der Impulsfolgen in je zumindest zwei verschiedenen Zählern einer Vorzähler-Messeinheit,
3. digitale Differenzbildung der beiden Zählerstände der Vorzähler-Messeinheit,
4. Wandlung des digitalen Differenzergebnisses der Vorzähler-Messeinheit in ein erstes Analogsignal,
5. Abfrage der Vorzähler-Messeinheit nach positivem oder negativem Überlauf,
6. bei Überlauf Erzeugung von entsprechenden Überlaufimpulsen,
7. bei Abgabe von Überlaufimpulsen Inversion des höchsten Bits am Addiererausgang der Vorzähler-Messeinheit,
8. Zählen der positiven Überlaufimpulse bzw. der negativen Überlaufimpulse in je zumindest zwei verschiedenen Zählern einer Überlaufzähler-Messeinheit,
9. digitale Differenzbildung der beiden Zählerstände der Überlaufzähler-Messeinheit,
10. Wandlung des digitalen Differenzergebnisses der Überlaufzähler-Messeinheit in ein zweites Analogsignal,
11. analoge Addition des ersten und zweiten Analogsignals zu einem dritten Analogsignal,
12. Dekodierung des dritten Analogsignales und
13. Anzeige des dekodierten dritten Analogsignales als Mass für die Phasenlage bzw. Phasenverschiebung.

2. Verfahren nach Anspruch 1, dadurch gekennzeichnet, dass die digitale Differenzbildung durch digitale Addition der beiden Zählerstände eines Vorwärts- und eines Rückwärtszählers erfolgt.

3. Verfahren nach einem oder mehreren der vorangehenden Ansprüche, dadurch gekennzeichnet, dass die digitale Differenzbildung durch digitale Subtraktion der beiden Zählerstände zweier Vorwärts- oder zweier Rückwärtszähler erfolgt.

4. Verfahren nach einem oder mehreren der vorangehenden Ansprüche, dadurch gekennzeichnet, dass die Dekodierung des Analogsignales durch Tiefpassfilterung erfolgt.

5. Verfahren nach einem oderer mehreren der vorangehenden Ansprüche, gekennzeichnet durch folgende Verfahrensschritte:

1. Erzeugung eines Abtastintervalles,
2. Vorgabe und Speicherung des Abtastintervalles,
3. Null-Setzung des Phasenwinkels zu Beginn des Abtastintervalles,
4. Speicherung des während des Abtastintervalles aufgelaufenen Phasenwinkels,
5. erneute Null-Setzung des Phasenwinkels nach Ablauf des Abtastintervalles und
6. Anzeige des gespeicherten Phasenwinkels $\Delta \varphi$ pro Abtastintervall.

6. Verfahren nach einem oder mehreren der vorangehenden Ansprüche, dadurch gekennzeichnet, dass das Abtastintervall umdrehungs-, winkel- oder zeitbezogen ist.

7. Verfahren nach Anspruch 6, gekennzeichnet durch folgende Verfahrensschritte:

1. Abtasten und Speichern des zur Anzeige vorgesehenen, dem Differenzdrehwinkel $\Delta \varphi$ proportionalen Analogsignales,
2. Erzeugung eines Zeitintervalles durch ein separates Zeitglied,
3. Division durch das Zeitintervall zwischen den Abtastungen und
4. Ausgabe eines der Differenzwinkelgeschwindigkeit $\Delta \varphi$ proportionalen Analogsignales.

8. Verfahren nach Anspruch 6, gekennzeichnet durch folgende Verfahrensschritte:

1. Abtasten und Speichern des zur Anzeige vorgesehenen, dem Differenzdrehwinkel $\Delta \varphi$ proportionalen Analogsignales,
2. Erzeugung eines Zeitintervalles durch zumindest einen inkrementalen Drehgeber oder einen Zähler,
3. Division durch den Winkelbereich zwischen den Abtastungen und
4. Ausgabe eines dem Differenzdrehwinkel pro Winkel

$$\frac{\Delta \varphi}{\varphi}$$

oder pro Umdrehung

$$\frac{\Delta \varphi}{U}$$

proportionalen Analogsignales.

9. Verfahren nach einem der Ansprüche 6, 7 oder 8, dadurch gekennzeichnet, dass das zur Anzeige vorgesehene dem Differenzdrehwinkel $\Delta \varphi$ proportionale Analogsignal zur Frequenzbestimmung herangezogen wird.

10. Verfahren nach Anspruch 9, dadurch gekennzeichnet, dass die Frequenzbestimmung durch Zählen der Überläufe bzw. der Überlauffrequenz pro Zeiteinheit in einem Frequenzzähler erfolgt.

11. Verfahren nach einem oder mehreren der vorangehenden Ansprüche, dadurch gekennzeichnet, dass vor der Frequenzbestimmung das zur Anzeige vorgesehene, dem Differenzwinkel $\Delta \varphi$ proportionale Analogsignal in ein Rechtecksignal umgewandelt wird.

12. Vorrichtung zur Durchführung des Verfahrens nach Anspruch 1, mit zwei Rotationskörpern, an denen jeweils ein inkrementaler Drehgeber angeordnet ist, dadurch gekennzeichnet, dass den inkrementalen Drehgebern (3 und 4) eine Vorzähler-Messeinheit (20) nachgeschaltet ist, die über einen Analog-Komparator (22) und einen Bit-Invertierer (23) mit einer Überlaufzähler-Messeinheit (21) gekoppelt ist, wobei die beiden Messeinheiten (20 und 21) aus je zumindest zwei verschiedenen Zählern (5 und 6), einem mit den Zählern (5 und 6) verbundenen, gemeinsamen Differenzbilder (7) und einem diesem nachgeschalteten Digital/Analog-Konverter (8) bestehen, und dass beiden Messeinheiten (20 und 21) in Reihe ein gemeinsamer Analog-Addierer (24), ein Tiefpassfilter (9) sowie eine Anzeigevorrichtung (10) nachgeschaltet sind.

13. Vorrichtung nach Anspruch 12, dadurch

gekennzeichnet, dass die beiden Zähler (5 und 6) als ein Vorwärts- und Rückwärtsdigitalzähler und der Differenzbilder (7) als digitaler Addierer ausgebildet sind.

14. Vorrichtung nach Anspruch 12, dadurch gekennzeichnet, dass beide Zähler (5 und 6) als Vorwärts- oder Rückwärtsdigitalzähler und der Differenzbilder (7) als digitaler Subtrahierer ausgebildet sind.

15. Vorrichtung nach einem oder mehreren der Ansprüche 12 bis 14, dadurch gekennzeichnet, dass der die beiden Zähler (5 und 6) der Überlaufzähler-Messeinheit (21) aktivierende Bit-Invertierer (23) zwischen dem das höchstwertige Bit übertragenden Ausgang des digitalen Addierers (7) und den Digital/Analog-Konverter (8) zwischengeschaltet und mit dem Analog-Komparator (22) gekoppelt ist, der die Überlaufzähler-Messeinheit (21) und den Bit-Invertierer (23) steuert.

16. Vorrichtung nach Anspruch 12, dadurch gekennzeichnet, dass zwischen dem Tiefpassfilter (9) und der Anzeigevorrichtung (10) ein taktgesteuertes Speicherglied (30) zwischengeschaltet ist.

17. Vorrichtung nach Anspruch 16, dadurch gekennzeichnet, dass das taktgesteuerte Speicherglied (30) zur Taktsteuerung zumindest mit einem der beiden inkrementalen Drehgeber (3 bzw. 4), einem der beiden Zähler (5 bzw. 6) oder einem separaten Zeitglied (31) gekoppelt ist.

18. Vorrichtung nach Anspruch 16 oder 17, dadurch gekennzeichnet, dass das taktgesteuerte Speicherglied (30) als Sample and Hold ausgebildet ist.

19. Vorrichtung nach Anspruch 12 oder 16, dadurch gekennzeichnet, dass vor der Anzeigevorrichtung (10) ein Frequenzzähler (32) angeordnet ist.

20. Vorrichtung nach Anspruch 19, dadurch gekennzeichnet, dass dem Frequenzzähler (32) ein Signalwandler (33) vorgeschaltet ist.

21. Vorrichtung nach Anspruch 20, dadurch gekennzeichnet, dass der Signalwandler (33) als Schmitt-Trigger ausgebildet ist.

**Claims**

1. Characterizing feature of procedure for high precision measurement of the phase position or phase shift of two pulse sequences, in which, by way of example, the angles of rotation of two revolving bodies are quantized, converted by incremental encoders to pulse sequences subsequently used to determine the phase position or the phase shift, are the following steps:

1. Division of the measuring range to extend the measuring range dependent on the phase angle into a preliminary counter measuring range overflow counter measuring range,
2. Counting the pulse sequences in at least two different counters of one preliminary counter measuring unit,
3. Digital subtraction of both counter readings of the preliminary counter measuring unit,
4. Conversion of the digital difference result of the preliminary counter measuring unit into a first analog signal,
5. Interrogation of the preliminary counter measuring unit with regard to positive or negative overflow,
6. In the case of overflow, generation of corresponding overflow pulses,
7. In the case of output of overflow pulses, inversion of the high-order bit at the adder output of the preliminary counter measuring unit,
8. Counting the positive overflow pulses or the negative overflow pulses in at least two different counters of an overflow counter measuring unit,
9. Digital subtraction of both counter readings of the overflow measuring unit,
10. Conversion of the digital difference result of the overflow counter measuring unit into a second analog signal,
11. Analog addition of the first and second analog signal to a third analog signal
12. Decoding the third analog signal and,
13. Display of the decoded third analog signal as a measure for the phase position or phase shift.

2. Characterizing feature of procedure in accordance with Claim 1 is that the digital subtraction takes place by digital addition of both counter readings of a forward counter and a backward counter.

3. Characterizing feature of procedure in accordance with one or several of the aforementioned claims is that the digital subtraction takes place by digital subtraction of the two counter readings of two forward counters or two backward counters.

4. Characterizing feature of procedure in accordance with one or several of the aforementioned claims is that decoding of the analog signal takes place by means of low-pass filtering.

5. Characterizing feature of procedure in accordance with one or several of the aforementioned claims are the following steps:

1. Generation of a sampling interval,
2. Specification and storage of the sampling interval,
3. Zero setting of the phase angle at the beginning of the sampling interval,
4. Storage of the phase angle produced during the sampling interval,
5. Renewed zero setting of the phase angle after the sampling interval has elapsed and
6. Display of the stored phase angle per sampling interval.

6. Characterizing feature of procedure in accordance with one or several of the aforementioned claims is that the sampling interval is referred to revolution, angle or time.

7. Characterizing feature of procedure in accordance with Claim 6 are the following steps:

1. Sampling and storage of the analog signal proportional to the differential angle of rotation intended for display,
2. Generation of a time interval by a separate time element,
3. Division by the time interval between the sampling intervals and
4. Output of an analog signal proportional to the differential angular velocity.

8. Characterizing feature of procedure in accordance with Claim 6 are the following steps:

1. Sampling and storage of the analog signal proportional to the differential angle of rotation intended for display,
2. Generation of a time interval by at least one incremental encoder or one counter,
3. Division by the angular range between the sampling intervals and
4. Output of an analog signal proportional to the differential angle of rotation per angle or per revolution.

9. Characterizing feature of procedure in accordance with one of the Claims 6, 7 or 8 is that the analog signal proportional to the differential angle of rotation intended for display is used for frequency definition.

10. Characterizing feature of procedure in accordance with Claim 9 is that the frequency is determined by counting the overflows or the overflow frequency per unit of time in a frequency counter.

11. Characterizing feature of procedure in accordance with one or several of the aforementioned claims is that prior to frequency definition, the analog signal proportional to the differential angle intended for display is converted into a square wave signal.

12. Characterizing feature of device implementing the procedure in accordance with Claim 1, with two rotational bodies, to each of which an incremental encoder is assigned, is that connected downstream of the incremental encoders (3 and 4) is a preliminary counter measuring unit (20) which is linked via an analog comparitor (22) and a bit inverter (23) to an overflow counter measuring unit (24), with the two measuring units (20 and 21) each consisting of at least two different counters (5 and 6), a common subtractor (7) connected to the counters (5 an 6) and a subsequently connected digital/analog converter (8), and that connected in series downstream of the two measuring units (20 and 21) are a common analog adder (24) a lowpass filter (9) and a display facility (10).

13. Characterizing feature of device in accordance with Claim 12 is that the two counters (5 and 6) are designed as a forward and backward digital counter and the subtractor stage (7) is in the form of a digital adder.

14. Characterizing feature of device in accordance with Claim 12 is that both counters (5 an 6) are designed as a forward or backward digital counter and the subtractor stage (7) is in the form of a digital subtractor.

15. Characterizing feature of device in accordance with one or several of the Claims 12 to 14 is that the bit inverter (23) activating the two counters (5 and 6) of the overflow counter measuring unit (21) is connected between the output of the digital adder (7) transmitting the high-order bit and the digital/analog converter (8) and is coupled to the analog comparitor (22) which controls the overflow counter measuring unit (21) and the bit inverter (23).

16. Characterizing feature of device in accordance with Claim 12 is that a clock-controlled storage element (30) is connected between the low-pass filter (9) and the display unit (10).

17. Characterizing feature of device in accordance with Claim 16 is that the clock-controlled storage element (30) for clock pulse control is coupled to at least one of the two incremental encoders (3 or 4), one of the two counters (5 or 6) or a separate time element (31).

18. Characterizing feature of device in accordance with Claims 16 of 17 is that the clock-controlled storage element (30) is designed as a sample and hold stage.

19. Characterizing feature of device in accordance with Claims 12 or 16 is that a frequency counter (32) is arranged before the display unit (10).

20. Characterizing feature of device in accordance with Claim 19 is that a signal converter (33) is connected upstream of the frequency counter (32).

21. Characterizing feature of device in accordance with Claim 20 is that the signal converter (33) is designed as a Schmitt trigger.

**Revendications**

1. Procédé pour mesurer avec grande précision la position de phase et le déphasage de deux séquences d'impulsions, où par exemple les angles de rotation de deux corps rotatifs sont quantifiés, convertis par des transmetteurs incrémentaux de rotation en séquences d'impulsions qui sont traitées pour déterminer la position de phase ou de déphasage, caractérisé par les étapes opératoires suivantes:

1. Division du domaine de mesure en vue d'un élargissement de ce domaine de mesure en fonction de l'angle de phase en un domaine de mesure avec précompteur et un domaine de mesure avec compteur de débordement,
2. Comptage des séquences d'impulsions dans au moins deux compteurs différents d'une unité de mesure à précompteur,
3. Formation numérique de différence des deux valeurs de comptage de l'unité de mesure à précompteur,
4. Conversion du résultat numérique de différence de l'unité de mesure à précompteur en un premier signal analogique,

5. Interrogation de l'unité de mesure à précompteur après un débordement positif ou négatif,

6. En cas de débordement, génération d'impulsions de débordement correspondantes,

7. Lors de la production d'impulsions de débordement, inversion du bit maximal à la sortie d'additionneur de l'unité de mesure à précompteur,

8. Comptage des impulsions de débordement positives ou des impulsions de débordement négatives dans au moins deux compteurs différents d'une unité de mesure à compteur de débordement,

9. Formation numérique de différence des deux valeurs de compteurs de l'unité de mesure à compteur de débordement,

10. Conversion du résultat numérique de différence de l'unité de mesure à compteur de débordement en un second signal analogique,

11. Addition analogique du premier et du second signal analogique sous forme d'un troisième signal analogique,

12. Décodage du troisième signal analogique, et

13. Affichage du troisième signal analogique décodé comme mesure de la position de phase ou du déphasage.

2. Procédé selon la revendication 1, caractérisé en ce que la formation numérique de différence est effectuée par addition numérique des deux valeurs de compte d'un compteur progressif et d'un compteur régressif.

3. Procédé selon une ou plusieurs des revendications précédentes, caractérisé en ce que la formation numérique de différence est effectuée par soustraction numérique des deux valeurs de compte de deux compteurs progressifs ou de deux compteurs régressifs.

4. Procédé selon une ou plusieurs des revendications précédentes, caractérisé en ce que le décodage du signal analogique est effectué par filtrage passe-bas.

5. Procédé selon une ou plusieurs des revendications précédentes, caractérisé par les étapes opératoires suivantes:

1. Etablissement d'un intervalle d'analyse,

2. Définition et mémorisation de l'intervalle d'analyse,

3. Mise au zéro de l'angle de phase au début de l'intervalle d'analyse,

4. Mémorisation de l'angle de phase obtenu pendant l'intervalle d'analyse,

5. Nouvelle mise au zéro de l'angle de phase après terminaison de l'intervalle d'analyse, et

6. Affichage de l'angle de phase mémorisé $\Delta \varphi$ par intervalle d'analyse.

6. Procédé selon une ou plusieurs des revendications précédentes, caractérisé en ce que l'intervalle d'analyse est rapporté à un tour, un angle ou un temps.

7. Procédé selon la revendication 6, caractérisé par les étapes opératoires suivantes:

1. Analyse et mémorisation du signal analogique prévu pour l'affichage et proportionnel à l'angle de rotation différentiel $\Delta \varphi$,

2. Etablissement d'un intervalle de temps par un organe de temporisation séparé,

3. Division par l'intervalle de temps entre les analyses, et

4. Production d'un signal analogique proportionnel à la vitesse angulaire différentielle $\Delta \dot\varphi$.

8. Procédé selon la revendication 6, caractérisé par les étapes opératoires suivantes:

1. Analyse et mémorisation du signal analogique prévu pour l'affichage et proportionnel à l'angle de rotation différentiel $\Delta \varphi$,

2. Etablissement d'un intervalle de temps par au moins un transmetteur incrémental de rotation ou un compteur,

3. Division par la plage angulaire entre les analyses, et

4. Production d'un signal analogique proportionnel à l'angle de rotation différentiel par angle

$$\frac{\Delta \varphi}{\varphi}$$

ou par tour

$$\frac{\Delta \varphi}{U}\,.$$

9. Procédé selon une des revendications 6, 7 ou 8, caractérisé en ce que le signal analogique prévu pour l'affichage et proportionnel à l'angle de rotation différentiel $\Delta \varphi$ est utilisé pour une détermination de fréquence.

10. Procédé selon la revendication 9, caractérisé en ce que la détermination de fréquence est effectuée par comptage des débordements ou de la fréquence de débordement par unité de temps dans un compteur de fréquence.

11. Procédé selon une ou plusieurs des revendications précédentes, caractérisé en ce que, avant la détermination de fréquence, le signal analogique prévu pour l'affichage et proportionnel à l'angle différentiel $\Delta \varphi$ est converti en un signal rectangulaire.

12. Dispositif pour la mise en œuvre du procédé selon la revendication 1, comportant deux corps rotatifs sur chacun desquels est disposé un transmetteur incrémental de rotation, caractérisé en ce qu'il est prévu à la suite des transmetteurs incrémentaux de rotation (3 et 4) une unité de mesure à précompteur (20), qui est reliée par l'intermédiaire d'un comparateur analogique (22) et d'un inverseur de bits (23) avec une unité de mesure à compteur de débordement (21), les deux unités de mesure (20 et 21) sont constituées chacune d'au moins deux compteurs différents (5 et 6), d'un formateur de différence commun (7) relié aux compteurs (5 et 6), et d'un convertisseur numérique/analogique (8) placé à la suite de celui-ci, et en ce qu'il est prévu à la suite des deux unités de mesure (20 et 21), en série, un additionneur analogique commun (24), un filtre passe-bas (29) ainsi qu'un dispositif d'affichage (10).

13. Dispositif selon la revendication 12, caractérisé en ce que les deux compteurs (5 et 6) sont agencés sous forme d'un compteur numérique progressif et dégressif et le formateur de différence (7) est agencé sous forme d'un additionneur numérique.

14. Dispositif selon la revendication 12, caractérisé en ce que les deux compteurs (5 et 6) sont agencés comme des compteurs progressifs ou régressifs et le formateur de différence (7) est agencé comme un soustracteur numérique.

15. Dispositif selon une ou plusieurs des revendications 12 à 14, caractérisé en ce que l'inverseur de bits (23) assurant l'excitation des deux compteurs (5 et 6) de l'unité de mesure à compteur de débordement (21) est branché entre la sortie de l'additionneur numérique (7) qui transmet le bit de poids le plus fort et le convertisseur numérique/analogique (8) et est relié au comparateur analogique (22), qui commande l'unité de mesure à compteur de débordement (21) et l'inverseur de bits (23).

16. Dispositif selon la revendication 12, caractérisé en ce qu'il est prévu un organe de mémorisation (30) à commande synchronisée entre le filtre passe-bas (9) et le dispositif d'affichage (10).

17. Dispositif selon la revendication 16, caractérisé en ce que l'organe de mémorisation (30) à commande synchronisée est relié, en vue d'une commande de synchronisation, au moins avec un des deux transmetteurs incrémentaux de rotation (3 ou 4), un des compteurs (5 ou 6) ou un organe de temporisation séparé (31).

18. Dispositif selon la revendication 16 ou 17, caratérisé en ce que l'organe de mémorisation (30) à commande synchronisée est agencé comme un composant échantillonneur-bloqueur.

19. Dispositif selon la revendication 12 ou 16, caractérisé en ce qu'un compteur de fréquence (32) est branché avant le dispositif d'affichage (10).

20. Dispositif selon la revendication 19, caractérisé en ce qu'un convertisseur de signaux (33) est branché avant le compteur de fréquence (32).

21. Dispositif selon la revendication 20, caractérisé en ce que le convertisseur de signaux (33) est agencé comme un déclencheur de Schmitt.

Fig. 1

0 086 409

Fig. 2

Fig. 3

Fig. 4

Ausgang des
ink.Drehgebers 2

Fig. 5

Ausgang des
ink.Drehgebers 1

## Fig. 6

Zählerstand:

## Fig. 7

Zahl am Ausgang des Addierers der Vorzähler-Meßeinheit

## Fig. 8

Ausgangssignal des D/A-Konverters der Vorzähler-Meßeinheit

Fig. 9

25 · 26

$\varphi_1(t)=0$ · $\varphi_2(t)=0$ · $\varphi_1(t)=0$

28 · 29

Analogsignal 1 der Vorzähler-Meßeinheit

27

Fig. 10

Analogsignal 2 der Überlaufzähler-Meßeinheit

$4\varphi_Q$

Fig. 11

Ausgang am gemeinsamen Analogaddierer

12

$(\varphi_Q = \Delta U)$

27

21

Fig. 12

| 2 | | | | |
| $\varphi_2$ | Drehgeber 2 (4) | Vorwärts Zähler (5) | | |
| $\varphi_1$ | Drehgeber 1 (3) | Rückw. Zähler (6) | | |

Tiefpaß Filter (9) — Sample and Hold (30) $\frac{\Delta\varphi}{Umdr}$ $\left(\frac{\Delta\varphi}{\varphi}\right)$ $\left(\frac{\Delta\varphi}{T}\right)$ — Anzeige (10)

Oszillator (31)

0 086 409

Fig. 13

(9)30                    32                    10

| Sample and Hold | Frequenz Zähler | Anzeige |

Fig. 14

9(30)              33                32                10

| Tiefpaß Filter | Signal Wandler | Frequenz Zähler | Anzeige |

# Fig. 15

Frequensspanng.- wandler    Subtrohierer    Dividierer

$\varphi_2$ — Drehgeber 2 — $f_2 / U_2$ — $U_1 - U_2$ — $\dfrac{U_1 - U_2}{U_1}$   $\dfrac{\Delta U}{U}$

$\varphi_1$ — Drehgeber 1 — $f_1 / U_1$

Fig. 16

# Fig. 17